# EUROPEAN PATENT APPLICATION

(11) **EP 4 255 130 A1**
(43) Date of publication of application: **04.10.2023**
(21) Application number: 21897941.7
(22) Date of filing: 24.11.2021
(51) Int. Cl.: H05K 3/46

(54) **PRINTED WIRING BOARD AND METHOD FOR MANUFACTURING PRINTED WIRING BOARD**

(30) Priority: 27.11.2020 JP 2020196813
(71) Applicant: Kyocera Corporation, Kyoto-shi Kyoto 612-8501 (JP)
(72) Inventor: SAEKI, Shinri, Kyoto-shi, Kyoto 612-8501 (JP); ISHIOKA, Takashi, Kyoto-shi, Kyoto 612-8501 (JP)
(74) Representative: Viering, Jentschura & Partner mbB Patent- und Rechtsanwälte
(86) International application number: PCT/JP2021/042894
(87) International publication number: WO 2022/113968

(57) **Abstract**

A printed wiring board includes a multilayer substrate. The multilayer substrate includes a core layer and a build-up layer. The build-up layer is stacked on one surface of the core layer and constitutes a first surface of the multilayer substrate. The multilayer substrate is provided with a via conductor that penetrates through the core layer and the build-up layer in a thickness direction. The via conductor includes a filled via and a conformal via electrically connected to the filled via. At least part of the filled via overlaps the conformal via when viewed in the thickness direction and the filled via is positioned towards the first surface relative to the conformal via.

## Description

### TECHNICAL FIELD

The present disclosure relates to a printed wiring board and a printed wiring board manufacturing method.

### BACKGROUND OF INVENTION

In the related art, there are printed wiring boards that include multiple conductor layers separated by insulating layers, and these multiple conductor layers are electrically connected to each other by via conductors and through-hole conductors in order to form a three-dimensional circuit.

An example of a via conductor is one formed by connecting a filled via and a conformal via to each other in a thickness direction. The filled via is formed by filling a via hole provided in an insulating layer and the conformal via is provided along the side and bottom of a via hole. A recess formed by the conductor of a conformal via is usually filled with resin or another material. Japanese Unexamined Patent Application Publication No. 2003-224364 discloses a technique for ensuring the flatness of each layer by providing filled vias in an inner layer of a printed wiring board and providing conformal vias in the outermost layer of a build-up layer.

### SUMMARY

In an aspect of the present disclosure, a printed wiring board includes a multilayer substrate. The multilayer substrate includes a core layer and a build-up layer. The build-up layer is stacked on one surface of the core layer and constitutes a first surface of the multilayer substrate. The multilayer substrate is provided with a via conductor that penetrates through the core layer and the build-up layer in a thickness direction. The via conductor includes a filled via and a conformal via electrically connected to the filled via. At least part of the filled via overlaps the conformal via when viewed in the thickness direction and the filled via is positioned towards the first surface relative to the conformal via.

In an aspect of the present disclosure, a printed wiring board manufacturing method includes forming a via-hole-formed element by forming a first via hole from one surface of a core layer element and forming a second via hole from another surface of the core layer element, the core layer element to become a core layer. The manufacturing method further includes forming a plated-via-formed element by performing a plating process on the via-hole-formed element and forming a first filled via in the first via hole and forming a conformal via in the second via hole, the conformal via being electrically connected to the first filled via. The manufacturing method further includes forming a multilayer substrate element by stacking a build-up sheet on at least the one surface of the plated-via-formed element, the build-up sheet to become a build-up layer. The manufacturing method further includes forming a via-hole-formed multilayer substrate element by forming a third via hole at a position overlapping at least part of the conformal via when viewed in a thickness direction, the third via hole being formed from a surface of the multilayer substrate element on a side where the one surface is located. The manufacturing method further includes forming a second filled via in the third via hole by performing a plating process on the via-hole-formed multilayer substrate element, the second filled via being electrically connected to the first filled via.

### BRIEF DESCRIPTION OF THE DRAWINGS

FIG. 1 is a sectional view of a printed wiring board according to an embodiment.
FIG. 2 is a sectional view for describing a method for manufacturing a printed wiring board.
FIG. 3 is a sectional view for describing a method for manufacturing a printed wiring board.
FIG. 4 is a sectional view for describing a method for manufacturing a printed wiring board.
FIG. 5 is a sectional view for describing a method for manufacturing a printed wiring board.
FIG. 6 is a sectional view for describing a method for manufacturing a printed wiring board.
FIG. 7 is a sectional view for describing a method for manufacturing a printed wiring board.
FIG. 8 is a sectional view for describing a method for manufacturing a printed wiring board.
FIG. 9 is a sectional view for describing a method for manufacturing a printed wiring board.
FIG. 10 is a sectional view for describing a method for manufacturing a printed wiring board.
FIG. 11 is a sectional view for describing a method for manufacturing a printed wiring board.
FIG. 12 is a sectional view for describing a method for manufacturing a printed wiring board of a comparative example.
FIG. 13 is a sectional view for describing a method for manufacturing a printed wiring board of a comparative example.
FIG. 14 is a sectional view for describing a method for manufacturing a printed wiring board of a comparative example.
FIG. 15 is a sectional view for describing a method for manufacturing a printed wiring board of a comparative example.
FIG. 16 is a sectional view of a printed wiring board according to a variation.

### DESCRIPTION OF EMBODIMENTS

Hereafter, an embodiment will be described based on the drawings. However, for convenience of explanation, each figure referred to below illustrates only the main components that are necessary to explain the embodiment in a simplified manner. Therefore, a printed wiring board 1 of the present disclosure may include any components not illustrated in the referenced figures. The dimensions of the components in each figure are not a faithful representation of the actual dimensions and dimensional proportions of the components.

### (Configuration of Printed Wiring Board)

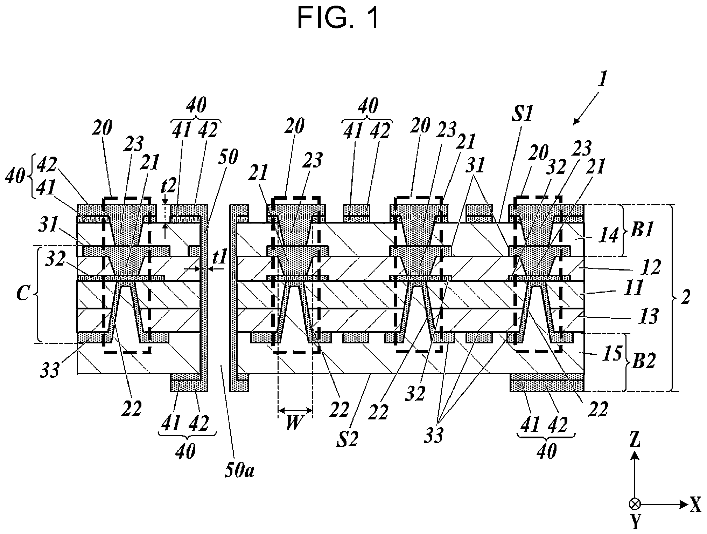

The configuration of a printed wiring board 1 according to an embodiment will be described while referring to FIG. 1.

The printed wiring board 1 is a multilayer antenna substrate that contains an antenna used for millimeter-wave radar or the like, and transmission lines used to transmit signals received by the antenna. Hereafter, the orientations of the individual parts of the printed wiring board 1 are described using an XYZ Cartesian coordinate system in which the Z direction is equivalent to the thickness direction of the printed wiring board 1. A surface of each layer constituting the printed wiring board 1 facing in the +Z direction is also referred to as a "top surface" and a surface of each layer facing in the -Z direction is also referred to as a "bottom surface". The Z direction is also referred to as a "thickness direction" of the printed wiring board 1.

The printed wiring board 1 includes a core layer C, first build-up layer B1 stacked on a top surface of the core layer C, and a second build-up layer B2 stacked on a bottom surface of the core layer C. In other words, the printed wiring board 1 includes a multilayer substrate 2 in which the second build-up layer B2, the core layer C, and the first build-up layer B1 are stacked in this order. Hereafter, the top surface of the multilayer substrate 2 is referred to as a first surface S1, and the bottom surface of the multilayer substrate 2 (the surface located on the opposite side from the first surface S1) is referred to as a second surface S2. The printed wiring board 1 may include additional components other than the multilayer substrate 2.

The core layer C includes insulating layers 11 to 13 and inner conductor layers 31 to 33. The insulating layers 11 to 13 are stacked in the Z direction. In more detail, the insulating layer 12 is stacked on the top surface of the insulating layer 11, and the insulating layer 13 is stacked on the bottom surface of the insulating layer 11. The number of insulating layers included in the core layer C is not limited to three, and may be two or less or four or more.

Examples of materials of the insulating layers 11 to 13 include organic resins such as epoxy resin, polyimide resin, polyphenylene ether (PPE) resin, polyphenylene oxide (PPO) resin, and cyanate ester resin. A mixture of two or more of these organic resins may be used. However, the insulating layers 11 to 13 are not limited to these materials and other insulating materials may be used. The insulating layers 11 to 13 may also contain a reinforcing material such as glass cloth. The insulating layers 11 to 13 may also contain inorganic filler (inorganic particles) such as aluminum hydroxide, silica, or barium sulfate.

The inner conductor layer 31 is formed on the top surface of the insulating layer 12. The inner conductor layer 32 is formed at the boundary between the insulating layer 11 and the insulating layer 12. The inner conductor layer 33 is formed on the bottom surface of the insulating layer 13. The inner conductor layers 31 to 33 form wiring line patterns. The material of the inner conductor layers 31 to 33 may be, but is not limited to, copper, for example. The number of conductor layers included in the core layer C is not necessarily three, and may be two or less or four or more depending on the number of insulating layers included in the core layer C and so on.

The first build-up layer B1 includes an insulating layer 14 stacked on the top surface of the core layer C and a surface layer conductor 40 formed on the top surface of the insulating layer 14. The top surface of the first build-up layer B1 constitutes the first surface S1 of the multilayer substrate 2. The first surface S1 includes the surface of the surface layer conductor 40 and the surfaces of the portions of the insulating layer 14 that are exposed from the surface layer conductor 40.

The second build-up layer B2 includes an insulating layer 15 stacked on the bottom surface of the core layer C and a surface layer conductor 40 formed on the bottom surface of the insulating layer 15. The bottom surface of the second build-up layer B2 constitutes the second surface S2 of the multilayer substrate 2. The second surface S2 includes the surface of the surface layer conductor 40 and the surfaces of the portions of the insulating layer 15 that are exposed from the surface layer conductor 40.

The insulating layers 14 and 15 include an insulating resin and a reinforcing material such as glass cloth embedded within the resin. Examples of resin materials constituting the insulating layers 14 and 15 include epoxy resin, bismaleimide-triazine resin, polyimide resin, polyphenylene ether (PPE) resin, phenol resin, polytetrafluoroethylene (PTFE) resin, silicon resin, polybutadiene resin, polyester resins, melamine resins, urea resins, polyphenylene sulfide (PPS) resins, polyphenylene oxide (PPO) resins, and so on. A mixture of two or more of these resins may be used. The insulating layers 14 and 15 may also contain inorganic filler such as aluminum hydroxide, silica or barium sulfate, or organic filler such as phenolic resin or methacrylic resin.

The surface layer conductor 40 is formed on the top surface of the insulating layer 14 and the bottom surface of the insulating layer 15 so as to form wiring line patterns. The surface layer conductor 40 includes a copper foil 41 on the surfaces of the insulating layers 14 and 15 and a plating layer 42 stacked on the copper foil 41. The material of the plating layer 42 may be copper, for example.

The multilayer substrate 2 is provided with via conductors 20 that penetrate through portions of the multilayer substrate 2 in the thickness direction. In more detail, the via conductors 20 penetrate through the core layer C and the first build-up layer B1 in the thickness direction, but do not penetrate through the second build-up layer B2. Each via conductor 20 includes a first filled via 21, a conformal via 22, and a second filled via 23, and has a stacked via structure in which these vias are connected to each other in the thickness direction. Among these vias, the first filled via 21 and the conformal via 22 penetrate through the core layer C, and the second filled via 23 penetrates through the first build-up layer B1. Hereafter, the first filled via 21 and the second filled via 23 are collectively referred to as "filled vias 21 and 23". The material of the filled vias 21 and 23 and the conformal via 22 may be copper, for example.

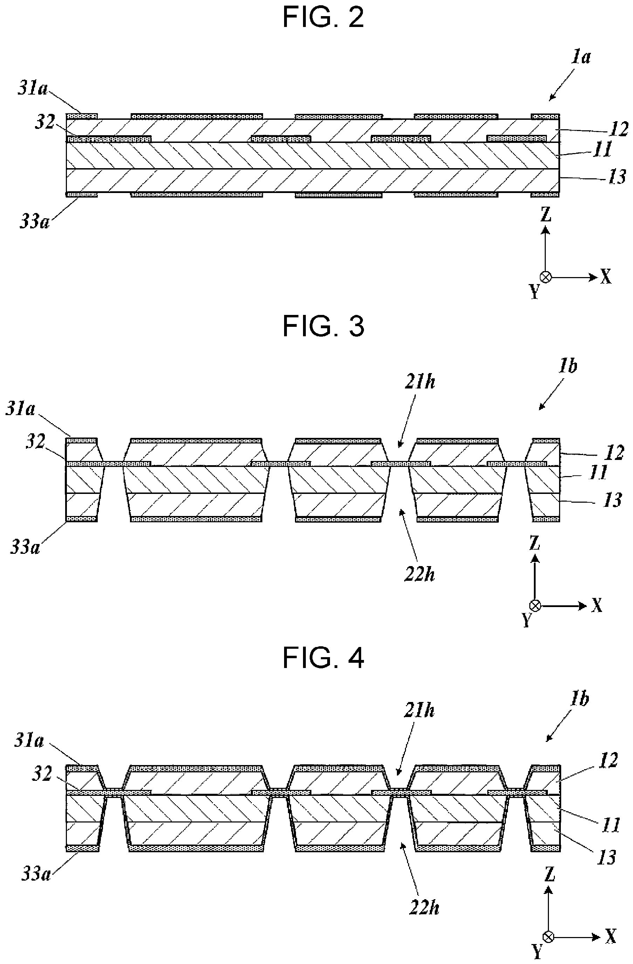

The first filled via 21 consists of a conductor that fills a first via hole 21h (refer to FIG. 3) provided in the insulating layer 12 and a part of the inner conductor layer 31 that overlaps the opening of the first via hole 21h. A land of the first filled via 21 consists of a portion of the inner conductor layer 31.

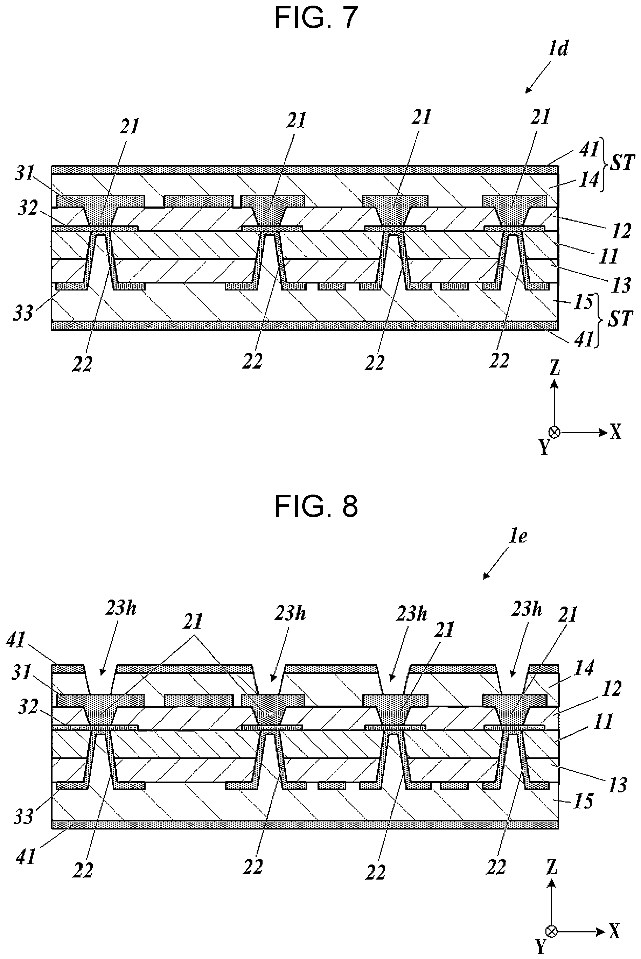

The second filled via 23 consists of a conductor that fills a third via hole 23h (refer to FIG. 8) provided in the insulating layer 14 and a part of the surface layer conductor 40 that overlaps the opening of the third via hole 23h. A land of the second filled via 23 consists of a portion of the surface layer conductor 40. The land may be connected to another wiring line formed by the surface layer conductor 40. In other words, the surface layer conductor 40 provided on the first surface S1 may be electrically connected to the via conductor 20.

The part of the first filled via 21 that fills the first via hole 21h and the part of the second filled via 23 that fills the third via hole 23h each have a conical trapezoidal shape having a cross-sectional area that decreases in size in the -Z direction (i.e., towards the bottoms of the first via hole 21h and the third via hole 23h). Hereafter, the part of the filled via 21 extending along the bottom of the first via hole 21h and the part of the second filled via 23 extending along the bottom of the third via hole 23h will be referred to as "via bottoms". The filled vias 21 and 23 are disposed so that their via bottoms face in the -Z direction. In other words, the filled vias 21 and 23 are provided so as to be orientated with their via bottoms positioned on the side where the conformal via 22 is located. The via bottom of the first filled via 21 is electrically connected to the inner conductor layer 32. The via bottom of the second filled via 23 is electrically connected to a surface (top surface) of the first filled via 21 on the opposite side from the via bottom of the first filled via 21. Thus, the filled vias 21 and 23 are connected to each other in the Z direction. The second filled via 23 is provided at a position so as to overlap the first filled via 21 when viewed in the thickness direction (Z direction). However, this configuration is not necessarily adopted, and a portion of the second filled via 23 may overlap the first filled via 21 when viewed in the thickness direction.

The conformal via 22 includes a conductor that is located along the side and the bottom of the second via hole 22h (refer to FIG. 3), which is provided so as to extend across the insulating layer 11 and the insulating layer 13. The space formed by the inner wall of the second via hole 22h has a conical shape with a cross-sectional area that decreases in size towards the +Z direction. The conductor of the conformal via 22 is shaped so as to extend along the side and bottom of the conical shape. The recess formed by the conductor of the conformal via 22 is filled by the insulating layer 15. A land of the conformal via 22 consists of a portion of the inner conductor layer 33. The land may be connected to another wiring line formed by the inner conductor layer 33.

Hereafter, the portion of the conformal via 22 that extends along the bottom of the second via hole 22h is referred to as a "via bottom". The conformal via 22 is provided so as to be oriented with the via bottom thereof positioned on the side where first filled via 21 is located (+Z direction side). The via bottom of the conformal via 22 is electrically connected to the inner conductor layer 32. Therefore, the via bottom of the first filled via 21 and the via bottom of the conformal via 22 face each other across the inner conductor layer 32. In other words, the first filled via 21 and the conformal via 22 share a via bottom.
Thus, the filled vias 21 and 23 and the conformal via 22 constituting the via conductor 20 are electrically connected to each other and are at the same potential.

The conformal via 22 is provided at a position so as to overlap the filled vias 21 and 23 when viewed in the thickness direction. In this embodiment, the entire filled vias 21 and 23 overlap the conformal via 22 when viewed in the thickness direction. However, this is not necessarily the case, and a portion of each of the filled vias 21 and 23 may overlap the conformal via 22 when viewed in the thickness direction.

The filled vias 21 and 23 are positioned towards the first surface S1 (+Z direction side) relative to the conformal via 22. In other words, in each via conductor 20, the second filled via 23, the first filled via 21, and the conformal via 22 are disposed in order from the first build-up layer B 1 side, which is located at the surface layer part on the first surface S1 side of the multilayer substrate 2, to the core layer C side. Therefore, the end portion of the via conductor 20 on the first surface S1 side (the end portion on the surface layer side of the multilayer substrate 2) is constituted by the second filled via 23. The end portion of the via conductor 20 on the opposite side from the first surface S1 is constituted by the conformal via 22, which is positioned inside the multilayer substrate 2.

Widths W of the filled vias 21 and 23 are equal to a width W of the conformal via 22 when viewed in the thickness direction. The widths of the filled vias 21 and 23, and the conformal via 22 are the diameters of the circles formed by the openings of the first via hole 21h, the second via hole 22h, and the third via hole 23h, respectively. If the openings have a different shape from a circle, the widths of the filled vias 21 and 23 and the conformal via 22 are the maximum diameters of the openings. FIG. 1 illustrates a cross-section perpendicular to the Y direction and passing through the centers of the circles formed by the openings. In the cross section, the widths W of the filled vias 21 and 23 are equal to the width W of the conformal via 22. In other cross sections passing through the centers of the above circles, the widths W of the filled vias 21 and 23 may also be equal to the width W of the conformal via 22.

The multilayer substrate 2 of the printed wiring board 1 includes a through hole 50a that extends through the multilayer substrate 2 from the first surface S1 to the second surface S2. A through-hole conductor 50 is provided on the inner wall of the through hole 50a. In other words, the through-hole conductor 50 is a tube-like conductor extending along the inner wall of the through hole 50a. A portion of the surface layer conductor 40 on the first surface S1 side and a portion of the surface layer conductor 40 on the second surface S2 side are electrically connected to the through-hole conductor 50. In other words, a portion of the surface layer conductor 40 on the first surface S1 side is electrically connected to a portion of the surface layer conductor 40 on the second surface S2 side by the through-hole conductor 50. The through-hole conductor 50 may be electrically connected to any one of the inner conductor layers 31 to 33.

In this embodiment, when the thickness of the through-hole conductor 50 is t1 and the thickness of the surface layer conductor 40 is t2, the thickness ratio t1/t2 is greater than or equal to 0.7 and less than or equal to 1.0. Alternatively, the thickness ratio t1/t2 may be greater than or equal to 0.9 and less than or equal to 1.0.

The volume percentage of conductor in the first build-up layer B1 is higher than the volume percentage of conductor in the core layer C as a result of the first build-up layer B1 including the surface conductor 40 that forms a circuit pattern. Here, the core layer C is assumed to include parts of the first filled vias 21, the conformal vias 22, and the through-hole conductor 50 that are located within the insulating layers 11 to 13. The first build-up layer B1 is assumed to include parts of the second filled vias 23 and the through-hole conductor 50 that are located inside the insulating layer 14.

In the printed wiring board 1 having the above-described configuration, the via conductors 20 can function as waveguides for transmitting signals received or transmitted by an antenna, for example.

The via conductors 20 may also function as the side walls of a waveguide for transmitting signals. In this case, multiple via conductors 20 are provided at positions so as to surround the waveguide when viewed in the thickness direction.

The through-hole conductor 50 can function as a connection circuit that supplies a power supply potential to another conductor layer (for example, the surface layer conductor 40 on the first surface S1 side) in a configuration where the power supply potential is supplied to the surface layer conductor 40 on the second surface S2 side, for example. In this case, the via conductors 20 can also be made to function as connection circuits for supplying a power supply potential by electrically connecting the through-hole conductor 50 to the via conductors 20 via the surface layer conductor 40 on the first surface S1 side or the inner conductor layers 31 to 33.

However, these are merely examples and the functions of the via conductors 20 and the through-hole conductor 50 are not limited to these examples.

### (Printed Wiring Board Manufacturing Method)

Next, a method for manufacturing the printed wiring board 1 will be described while referring to FIGs. 2 to 11.

First, as illustrated in FIG. 2, a core layer element 1a, which will become the core layer C, is prepared. The core layer element 1a includes the insulating layers 11 to 13, a base conductor 31a provided on the top surface of the insulating layer 12, the inner conductor layer 32 provided at the interface between the insulating layers 11 and 12, and a base conductor 33a provided on the bottom surface of insulating layer 13. The base conductor 31a, the inner conductor layer 32, and the base conductor 33a are composed of copper foil, for example.

Next, as illustrated in FIG. 3, a via-hole-formed element 1b is formed by forming the first via holes 21h from the top surface (one surface) of the core layer element 1a and forming the second via holes 22h from the bottom surface (other surface) of the core layer element 1a. Here, for example, the first via holes 21h are formed by radiating a laser from the top surface side of the core layer element 1a using the base conductor 31a as a mask. The second via holes 22h are formed by radiating a laser from the bottom surface side of the core layer element 1a using the base conductor 33a as a mask. The second via holes 22h are formed at positions overlapping the first via holes 21h when viewed in the thickness direction. The top surface of the inner conductor layer 32 is exposed at the bottoms of the first via holes 21h, and the bottom surface of the inner conductor layer 32 is exposed at the bottoms of the second via holes 22h.

Next, as illustrated in FIG. 4, electroless copper plating (chemical copper plating) is applied to the via-hole-formed element 1b so as to form a base plating layer on the surface of the via-hole-formed element 1b.

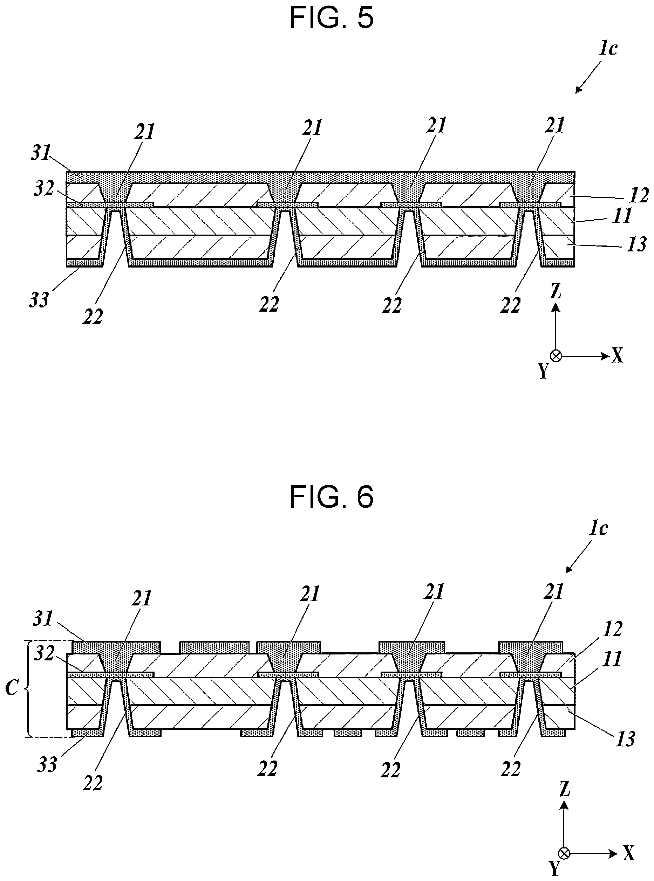

Next, as illustrated in FIG. 5, electrolytic copper plating is applied to the via-hole-formed element 1b so as to form the first filled vias 21 in the first via holes 21h and the conformal vias 22 in the second via holes 22h. Thus, a plated-via-formed element 1c is formed. The inner conductor layer 31 is formed on the top surface of the insulating layer 12, and the inner conductor layer 33 is formed on the bottom surface of the insulating layer 13. Here, the first via holes 21h are shallower in depth than the second via holes 22h. Therefore, when the plating process is simultaneously performed on the first via holes 21h and the second via holes 22h, the first via holes 21h are filled with the plating layer (conductor) to form the first filled vias 21, and the plating layer (conductor) is formed on the bottoms and the sides of the second via holes 22h to form the conformal vias 22. Thus, the first filled vias 21 and the conformal vias 22, which share via bottoms, can be formed by performing a plating process a single time. In addition, since the second via holes 22h do not need to be completely filled with a conductor to form the conformal vias 22, vias can be formed in the second via holes 22h that have a large layer spacing in the Z direction.

Next, as illustrated in FIG. 6, the inner conductor layer 31 and the inner conductor layer 33 are patterned in order to form wiring line patterns. For example, etch resist patterns are formed on the surfaces of the inner conductor layers 31 and 33, and then etching is performed so as to remove portions of the inner conductor layers 31 and 33, and then the etch resist is peeled off so as to form the wiring line patterns. In this way, the core layer C is completed.

Next, as illustrated in FIG. 7, build-up sheets ST, which will become build-up layers, are stacked on the top surface and the bottom surface of the plated-via-formed element 1c, and heating and pressing are performed in order to form a multilayer substrate element 1d. The build-up sheets ST are members that include a prepreg or resin film that will become the insulating layer 14 or 15 and the copper foil 41. Here, prepreg is a semi-cured member composed of glass cloth impregnated with resin. Resin films are semi-cured members composed of resin or resin and inorganic or organic filler.

With such build-up sheets ST stacked on both sides of the plated-via-formed element 1c, the plated-via-formed element 1c is heated and pressed in the Z direction. As a result, the prepregs or resin films melt once and then solidify and become the insulating layer 14 and the insulating layer 15, which are adhered to the surfaces of the core layer C. At this time, the resin (insulator) contained in the build-up sheets ST fills the recesses of the conformal vias 22. FIG. 7 depicts build-up sheets ST after the prepreg has adhered as the insulating layer 14 and the insulating layer 15.

Next, as illustrated in FIG. 8, from the top surface side of the multilayer substrate element 1d, third via holes 23h are formed at positions overlapping the first filled vias 21 and the conformal vias 22 when viewed in the thickness direction. Thus, a via-hole-formed multilayer substrate element 1e is formed. Here, the areas of the copper foil 41 where the third via holes 23h are to be formed are removed, and then the copper foil 41 is used as a mask to form the third via holes 23h by radiating a laser from the top surface of the multilayer substrate element 1d. The top surfaces of the first filled vias 21 are exposed at the bottoms of the third via holes 23h.

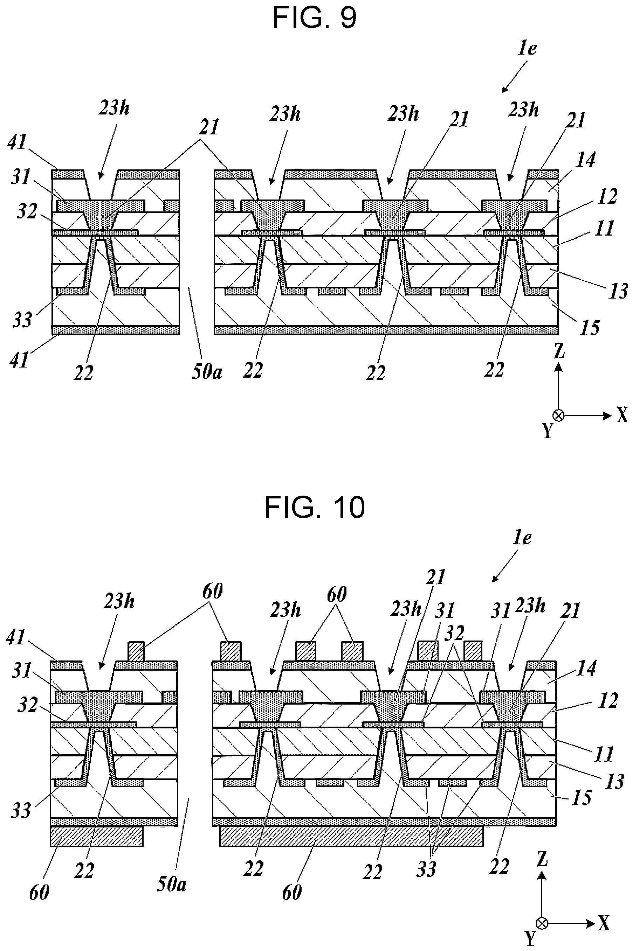

Next, as illustrated in FIG. 9, the through hole 50a is formed that extends through the via-hole-formed multilayer substrate element 1e in the thickness direction. For example, a desmear treatment is performed after forming the through hole 50a by drilling. If the through-hole conductor 50 is not necessary, the process of forming the through hole 50a illustrated in FIG. 9 is omitted. Hereafter, the via-hole-formed multilayer substrate element 1e having the through hole 50a formed therein is also referred to as a "through-hole-formed multilayer substrate element".

Next, the circuit pattern of the surface layer conductor 40 is formed using a modified semi-additive process (MSAP).

First, as illustrated in FIG. 10, a plating resist 60 is formed on the top surface and the bottom surface of the via-hole-formed multilayer substrate element 1e (or the through-hole-formed multilayer substrate element if the through hole 50a has been formed), except for in the areas where the wiring line pattern of the surface layer conductor 40 is to be formed.

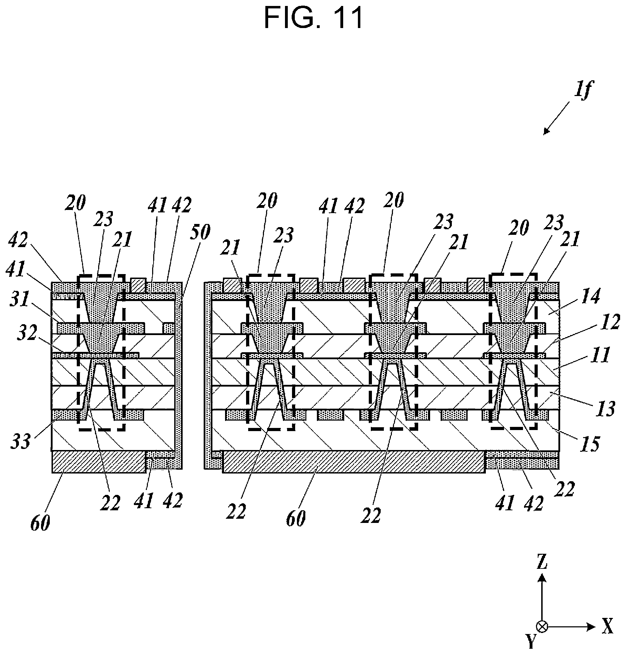

Next, electrolytic copper plating (pattern plating) is applied to the via-hole-formed multilayer substrate element 1e, as illustrated in FIG. 11. By applying the electrolytic copper plating, a plating layer 42 is formed on the copper foil 41 with the copper foil 41 exposed on the top and bottom surfaces being used as a seed layer. As a result of applying the electrolytic copper plating, the third via holes 23h are filled with a plating layer (conductor) so as to form the second filled vias 23, and the through-hole conductor 50 is formed on the inner wall of the through hole 50a. Thus, a plating-formed multilayer substrate element 1f is formed.

Next, the plating resist 60 is removed, and the copper foil 41 serving as a seed layer exposed after the removal of the plating resist 60 is removed by flash etching. As a result, the circuit pattern of the surface layer conductor 40 is formed on the top surface and bottom surface of the via-hole-formed multilayer substrate element 1e.

The printed wiring board 1 illustrated in FIG. 1 is completed through the above-described processes.

### (Comparison with Comparative Example)

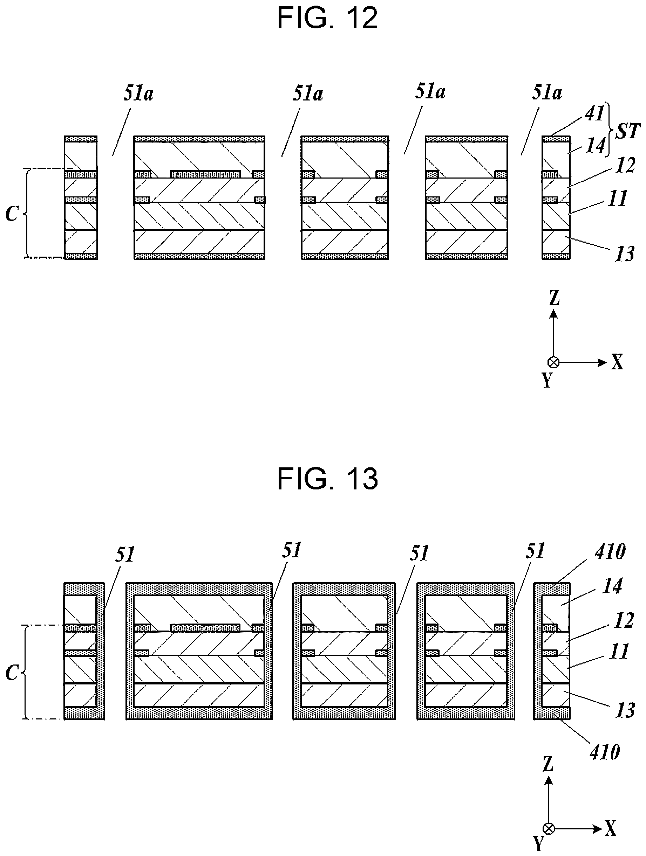

The method for manufacturing the printed wiring board 1 according to this embodiment described above will now be compared to a method of manufacturing a printed wiring board according to a comparative example illustrated in FIGs. 12 to 15, and the advantages of the manufacturing method of this embodiment will be explained.

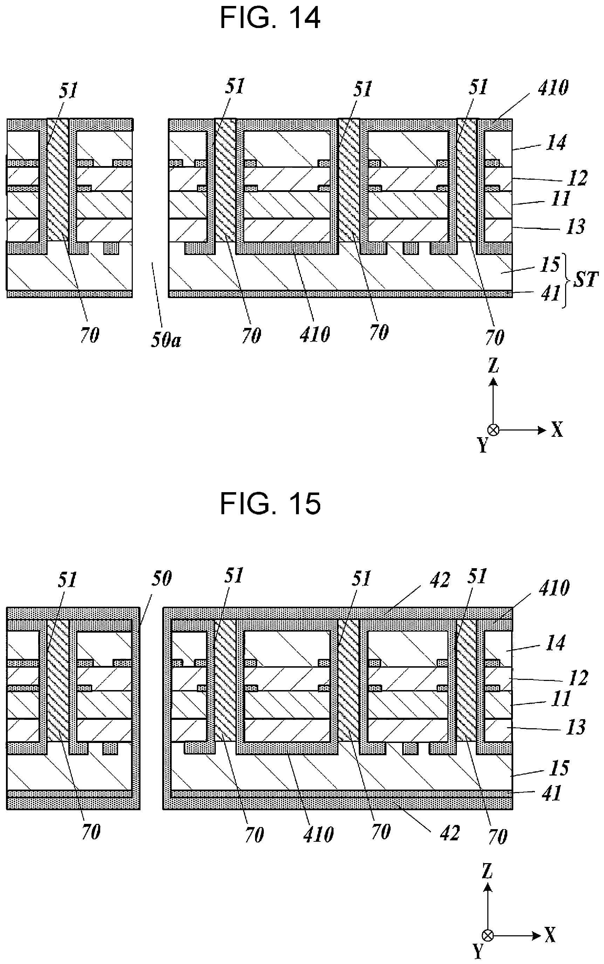

The printed wiring board according to the comparative example includes non-through-hole conductors 51 (refer to FIG. 15) in place of the via conductors 20 in the areas where the via conductors 20 of the printed wiring board 1 of this embodiment are formed.

In the method for manufacturing the printed wiring board according to the comparative example, first, as illustrated in FIG. 12, a build-up sheet ST is stacked on the top surface of a core layer C, and then heating and pressing are performed in order to form a substrate in which the insulating layer 14 and copper foil 41 are stacked on the core layer C. Then, through holes 51a are formed by performing drilling in the areas of the substrate where the via conductors 20 are formed in the above-described embodiment.

The substrate of the comparative example illustrated in FIG. 12 is vertically asymmetrical in shape with respect to the insulating layer 11 at the center of the core layer C and is consequently prone to warping, and this makes it difficult to automatically feed the substrate using a machine in a manufacturing line.

In contrast, in the manufacturing method of the above-described embodiment, since the core layer element 1a is shaped so as to be vertically symmetrical with respect to the insulating layer 11 when the first via holes 21h and the second via holes 22h are formed (refer to FIGs. 2 and 3), warping is unlikely to occur and automatic feeding of the substrate using a machine in a manufacturing line can be easily performed.

In the comparative example, the through holes 51a are formed by performing drilling with low processing positional accuracy, and this makes it difficult to form the through holes 51a at a narrow pitch.

In contrast, in the manufacturing method of the embodiment described above, the first via holes 21h and the second via holes 22h are formed using laser processing (refer to FIG. 3). Since laser processing has higher processing positional accuracy than drilling, narrower pitch processing is possible. In addition, faster processing is possible with laser processing than with drilling, and thus the lead time can be reduced.

Next, in the manufacturing method of the comparative example, as illustrated in FIG. 13, electroless copper plating is applied to the substrate in which the through holes 51a have been formed, and then electrolytic copper plating is applied. As a result, non-through-hole conductors 51 are formed on the inner walls of the through holes 51a. Plating layers 410 are also formed on the top and bottom surfaces of the substrate using these plating processes.

Next, as illustrated in FIG. 14, the through holes 51a are filled with resin 70 and the surfaces of the plating layers 410 are ground down in order to remove any unwanted resin and so forth. The plating layers 410 are patterned, and the insulating layer 15 and copper foil 41 are stacked on the bottom surface side by stacking the build-up sheet ST on the bottom surface, and then performing heating and pressing. After that, the through hole 50a that extends through the entire substrate is formed by drilling.

Here, in the comparative example, the process of filling the resin 70 and the process of grinding the substrate need to be performed, and therefore the manufacturing process is lengthened and the manufacturing cost is increased. In addition, since the substrate is prone to warping as described above, the thicknesses of the plating layers 410 after grinding are likely to vary. As a result, the dimensions of the plating layers 410 after grinding are not stable, and there is a tendency for the yield rate to decrease.

In contrast, grinding is not required in the manufacturing method of the above embodiment, and therefore the problems of the comparative example are less likely to occur, and the manufacturing process can be shortened and the manufacturing cost can be reduced compared to the comparative example.

Next, in the manufacturing method of the comparative example, as illustrated in FIG. 15, electroless copper plating is applied to the substrate in which the through hole 50a has been formed, and then electrolytic copper plating (panel plating) is applied. As a result, the through-hole conductor 50 is formed on the inner wall of the through hole 50a. Additionally, the plating layers 42 are formed on the top surface and the bottom surface of the substrate so as to overlap the plating layers 410. After that, the plating layers 410 and 42 on the top and bottom surfaces are patterned so as to form the circuit pattern of the surface layer conductor.

The top surface of the substrate illustrated in FIG. 15 is thickened by stacking the plating layer 410 and the plating layer 42 by performing electrolytic copper plating twice in FIG. 14 and FIG. 15. Therefore, performing patterning with MSAP using the plating layers 410 and 42 as seed layers is difficult. If pattern plating is performed with the plating resist 60 formed on the plating layer 42, the seed layers (plating layers 410 and 42) that are to be removed after removal of the plating resist 60 will be thick, and if the seed layer is removed by flash etching, the through-hole conductor 50 may disappear, the formed circuit pattern may be deformed from the desired shape, or the circuit width accuracy may be degraded due to the increased amount of etching. Therefore, even if MSAP is used with a thick seed layer, it will be difficult to form high-precision circuits, and the yield will not be stable. On the other hand, even if the plating layers 410 and 42, which serve as seed layers, are ground down to as thin as 3 µm to 5 µm so that MSAP can be applied, the substrate will tend to be warped by the thick seed layers, resulting in variations in the thickness of the seed layers after grinding and the loss of parts of the seed layers. Therefore, the use of MSAP is difficult in the manufacturing method of the comparative example, and the circuit pattern is formed by removing parts of the plating layers 410 and 42 using a subtractive method from the state illustrated in FIG. 15. However, forming high-precision circuits with the subtractive method is difficult.

In contrast, as illustrated in FIG. 10, the circuit pattern of the surface layer conductor 40 can be formed using MSAP with the copper foil 41 serving as the seed layer in a state where only the thin copper foil 41 formed on the surface. Since a grinding process is not required in this embodiment, the thickness of the copper foil 41 serving as the seed layer does not vary due to grinding, and the thickness of the copper foil 41 can be made uniform at from 3 µm to 5 µm. Thus, because the seed layer is thin and has little variation in thickness, the amount of flash etching needed to remove the copper foil 41 after the plating process can be reduced. Therefore, problems such as the disappearance of the through-hole conductor 50 or the surface layer conductor 40 due to flash etching are unlikely to occur. Therefore, MSAP can be used to form circuit patterns stably and precisely and the yield rate can be improved. Specifically, circuit width accuracy of ±10 µm or less can be achieved with a stable yield. Antenna substrates used in high-frequency bands such as the 76 Ghz band require high-precision circuit formation. According to the manufacturing method of this embodiment in which MSAP is used, formation of high-precision circuits that can be used in such high-frequency bands can be performed with a stable yield.

Since the plating layer 42 of the surface conductor 40 and the through-hole conductor 50 can be formed by applying electrolytic copper plating a single time, and since the surface conductor 40 consists of the plating layer 42 and the thin copper foil 41, the thickness ratio t1/t2 can be made close to one when the thickness of the through-hole conductor is t1 and the thickness of the surface layer conductor 40 is t2. More precisely, the thickness ratio t1/t2 can be made to be greater than or equal to 0.7 and less than or equal to 1.0.

Since the grinding process is not required, even if the substrate to be processed has a structure that is asymmetrical in the thickness direction, high-precision circuit formation can be performed with a stable yield. In addition, since a grinding process is not required, a reduction in yield due to dimensional abnormalities caused by physical grinding can be reduced.

### (Variation)

Next, a variation of the above-described embodiment will be described.

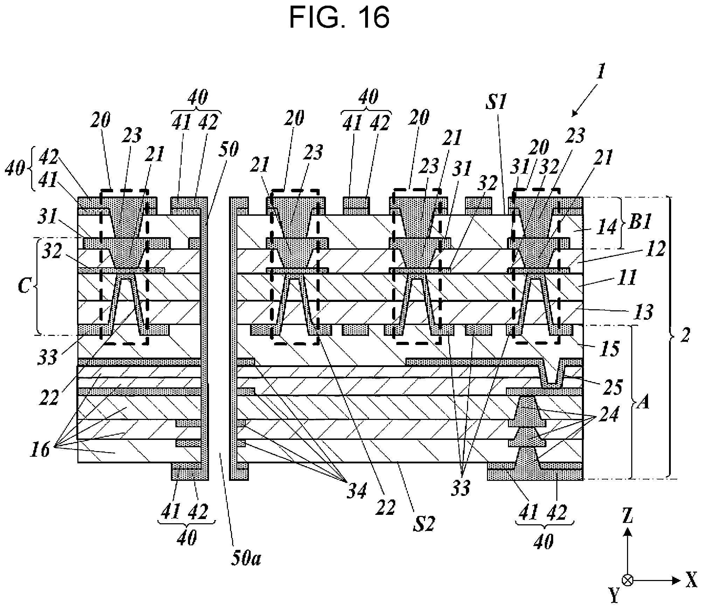

FIG. 16 is a sectional view of a printed wiring board 1 according to a variation.

The printed wiring board 1 of this variation differs from the above-described embodiment in that a control substrate A is provided on the -Z direction side of the core layer C in place of the second build-up layer B2. In other words, the printed wiring board 1 of this variation is a complex multilayer antenna substrate including a multilayer antenna substrate 2 that has a structure in which the control substrate A and a multilayer antenna substrate consisting of a core layer C and a first build-up layer B1 are formed in an integrated manner. In this variation, the bottom surface of the control substrate A constitutes the second surface S2 of the multilayer substrate 2. Hereafter, the differences from the above embodiment will be described.

The control substrate A includes the insulating layer 15 stacked on the bottom surface of the core layer C and five insulating layers 16 stacked on the -Z direction side of the insulating layer 15. The control substrate A also includes an inner conductor layer 34 provided between the insulating layers 15 and 16 and a surface layer conductor 40 that constitutes part of the second surface S2. The control substrate A also includes filled vias 24 and conformal vias 25 for electrically connecting the inner conductor layer 34 and the surface layer conductor 40 to each other in the thickness direction. The control substrate A may contain a configuration the same as or similar to that of the core layer C.

The thus-configured printed wiring board 1 according to this variation also includes the via conductors 20 that penetrate through the core layer C and the first build-up layer B1, the via conductors 20 each having a configuration in which the filled vias 21 and 23 and the conformal via 22 are connected to each other in the Z direction. The filled vias 21 and 23 overlap the conformal vias 22 when viewed in the thickness direction and are positioned towards the first surface S1 relative to the conformal vias 22. Therefore, effects the same as or similar to those in the above embodiment as described below are achieved.

### (Effects)

As described above, the printed wiring board 1 of this embodiment includes the multilayer substrate 2, and the multilayer substrate 2 includes the core layer C and the first build-up layer B 1. The first build-up layer B1 is stacked on one surface of the core layer C and constitutes the first surface S1 of the multilayer substrate 2. The multilayer substrate 2 is provided with the via conductors 20 that penetrate through the core layer C and the first build-up layer B1 in the thickness direction. Each via conductor 20 includes the filled vias 21 and 23 and the conformal via 22 electrically connected to the filled vias 21 and 23. The filled vias 21 and 23 overlap the conformal via 22 when viewed in the thickness direction and are positioned towards the first surface S1 relative to the conformal via 22.

According to this configuration, the second filled vias 23 are positioned on the surface layer side of the first build-up layer B 1 of the multilayer substrate 2, and the conformal vias 22 are positioned on the inner layer side of the multilayer substrate 2, that is, on the core layer C side. Here, since the recesses formed by the conductors in the conformal vias 22 are filled with resin, the thermal expansion coefficient of the conformal vias 22 is higher than that of the filled vias consisting only of metal due to the resin content. The first build-up layer B 1, which is located on the surface layer side of the multilayer substrate 2, usually has a higher volume percentage of metal (conductor) than the core layer C, which is located on the inner layer side. Therefore, according to the above configuration, the second filled vias 23 are positioned on the first build-up layer B1 side, where there is a large amount of metal, and the conformal vias 22 are positioned on the core layer C side, where the proportion of metal is relatively low and the resin component is large. As a result, the via conductors 20 readily follow the expansion and contraction deformation arising from the thermal expansion coefficients of the core layer C and the first build-up layer B 1. As a result, the via conductors 20 are less likely to break (fracture), and the reliability of printed wiring board 1 can be improved.

The conformal vias 22 penetrate through part of the core layer C, and the second filled vias 23 penetrate through the first build-up layer B1.

Consequently, the second filled vias 23, which have a thermal expansion coefficient close to that of the first build-up layer B 1, are positioned in the first build-up layer B 1, and the conformal vias 22, which have a thermal expansion coefficient close to that of the core layer C, are positioned in the core layer C. Therefore, the via conductors 20 readily follow the expansion and contraction deformation arising from the thermal expansion coefficients of the core layer C and the first build-up layer B 1. As a result, the via conductors 20 are even less likely to break, and the reliability of printed wiring board 1 can be further improved.

When viewed in the thickness direction, the width of the filled vias 21 and 23 is equal to the width of the conformal vias 22.

According to this configuration, the expansion and contraction deformation arising from the thermal expansion coefficients of the core layer C and the first build-up layer B1 is less likely to reach the regions around the filled vias 21 and 23 and the conformal vias 22. Therefore, the volumes of the parts of the multilayer substrate 2 whose dimensions change are smaller, and therefore the via conductors 20 are less likely to break, and the reliability of the printed wiring board 1 can be improved.

The multilayer substrate 2 includes the through hole 50a that extends through the multilayer substrate 2 in the thickness direction, and the through-hole conductor 50 is provided on the inner wall of the through hole 50a. The first build-up layer B 1 includes the surface layer conductor 40 that constitutes part of the first surface S 1, and the surface layer conductor 40 is electrically connected to the through-hole conductor 50. When the thickness of the through-hole conductor 50 is t1 and the thickness of the surface layer conductor 40 is t2, t1/t2 is greater than or equal to 0.7 and less than or equal to 1.0.

This allows impedance matching to be more easily achieved because the thickness of the through-hole conductor 50 and the thickness of the surface layer conductor 40 are closer to each other.

The surface layer conductor 40 is electrically connected to the via conductors 20.
As explained in the comparison with the comparative example, since the thickness of the surface layer conductor 40 can be reduced in this embodiment, the inductance from each via conductor 20 to the surface layer conductor 40 can be reduced in a configuration where the surface layer conductor 40 and the via conductors 20 are electrically connected to each other.

In addition, the first build-up layer B1 has a higher volume percentage of conductor than the core layer C.

In this configuration, as a result of providing the second filled vias 23 on the surface layer side of the first build-up layer B 1 and the conformal vias 22 on the core layer C side, the via conductors 20 can easily follow the expansion and contraction deformation arising from the thermal expansion coefficients of the core layer C and first build-up layer B1.

The first filled vias 21 are provided so as to be oriented with the via bottoms thereof positioned toward the conformal vias 22, and the conformal vias 22 are provided so as to be oriented with the via bottoms thereof positioned towards the first filled vias 21.

This enables the strength of the electrical connections between the first filled vias 21 and the conformal vias 22 to be increased.

The method for manufacturing the printed wiring board 1 of this embodiment also includes a step of forming the via-hole-formed element 1b by forming the first via holes 21h from one surface of the core layer element 1a, which will become the core layer C, and forming the second via holes 22h from the other surface of the core layer element 1a. The method also includes a step of forming the plated-via-formed element 1c by performing a plating process on the via-hole-formed element 1b to form the first filled vias 21 in the first via holes 21h and the conformal vias 22, which are electrically connected to the first filled vias 21, in the second via holes 22h. The method also includes a step of stacking the build-up sheet ST, which will become the first build-up layer B1, on at least one surface of the plated-via-formed element 1c in order to form the multilayer substrate element 1d. The method also includes a step of forming the via-hole-formed multilayer substrate element 1e by forming the third via holes 23h from the surface on one side of the multilayer substrate element 1d at positions overlapping the conformal vias 22 when viewed in the thickness direction. The method also includes a step of forming the second filled vias 23, which are electrically connected to the first filled vias 21, in the third via holes 23h by performing a plating process on the via-hole-formed multilayer substrate element 1e.

With this method, a thin seed layer (copper foil 41) can be provided on the surface of the first build-up layer B 1 before the plating process for forming the second filled vias 23, since a plating layer is not stacked on the surface of the first build-up layer B1 in the plating process. Therefore, the circuit pattern of the surface layer conductor 40 can be formed by MSAP in parallel with the formation of the second filled vias 23. This enables high-precision circuit formation with stable yields. In addition, since a grinding process is not required, the manufacturing process can be shortened and the manufacturing costs can be reduced, and a fall in yield due to dimensional abnormalities caused by physical grinding can be reduced.

In the step of forming the multilayer substrate element 1d, a build-up sheet ST is further stacked on the other surface of the plated-via-formed element 1c, and the recesses of the conformal vias 22 are filled with the insulating material contained in the build-up sheet ST.

This allows the recesses of the conformal vias 22 to be efficiently filled with the insulating material.

The method also includes a step of forming the through hole 50a that penetrates through the via-hole-formed multilayer substrate element 1e in the thickness direction before performing a plating process on the via-hole-formed multilayer substrate element 1e. In the step of performing a plating process on the via-hole-formed multilayer substrate element 1e, the second filled vias 23 are formed in the third via holes 23h and the through-hole conductor 50 is formed on the inner wall of the through-hole 50a by the plating process.

This allows the second filled vias 23 and the through-hole conductor 50 to be formed by performing a plating process a single time.

### (Other Considerations)

The above embodiment is merely an example, and may be modified in various ways. For example, in the above embodiment, an example configuration is illustrated in which one build-up layer is stacked on each of the top surface and the bottom surface of the core layer C. However, not limited to this configuration, two or more build-up layers may be stacked on the top surface and the bottom surface.

Although an example configuration is illustrated in which each via conductor 20 includes two filled vias 21 and 23, the number of filled vias may instead be one or three or more.

Although an example configuration in which each conformal via 22 penetrates through part of the core layer C is illustrated, the conformal vias 22 may instead penetrate through the entire core layer C.

Although an example configuration in which the widths of the filled vias 21 and 23, and the conformal vias 22 are equal to each other, some of these widths of may be different from the others.

Although a multilayer antenna substrate is illustrated as an example of a printed wiring board, applications of the printed wiring board of the present disclosure are not limited to this application.

Other specific details such as the configurations, structures, positions, and shapes illustrated in the above embodiment can be changed as appropriate so long as the changes do not depart from the spirit of the present disclosure. The configurations, structures, positional relationships, and shapes illustrated in the above embodiment can be combined with one another as appropriate so long as the resulting combinations do not depart from the spirit of the present disclosure.

### INDUSTRIAL APPLICABILITY

The present disclosure can be used for printed wiring boards and printed wiring board manufacturing methods.

### REFERENCE SIGNS

1 printed wiring board
1a core layer element
1b via-hole-formed element
1c via-formed element
1d multilayer substrate element
1e via-hole-formed multilayer substrate element
1f plating-formed multilayer substrate element
2 multilayer substrate
11 to 16 insulating layer
20 via conductor
21 first filled via
21h first via hole
22 conformal via
22h second via hole
23 second filled via
23h third via hole
24 filled via
25 conformal via
31 to 34 inner conductor layer
31a, 33a base conductor
40 surface layer conductor
41 copper foil
42 plating layer
50 through-hole conductor
50a through hole
51 non-through-hole conductor
51a throughhole
60 plating resist
70 resin
410 plating layer
A control substrate
B1 first build-up layer
B2 second build-up layer
C core layer
S1 first surface
S2 second surface
ST build-up sheet

## Claims

1. A printed wiring board comprising:
a multilayer substrate,
wherein the multilayer substrate includes a core layer and a build-up layer,
the build-up layer is stacked on one surface of the core layer and constitutes a first surface of the multilayer substrate,
the multilayer substrate is provided with a via conductor that penetrates through the core layer and the build-up layer in a thickness direction,
the via conductor includes a filled via and a conformal via electrically connected to the filled via, and
at least part of the filled via overlaps the conformal via when viewed in the thickness direction and the filled via is positioned towards the first surface relative to the conformal via.

2. The printed wiring board according to claim 1,
wherein the conformal via penetrates through at least part of the core layer and the filled via penetrates through the build-up layer.

3. The printed wiring board according to claim 1 or 2, wherein a width of the filled via is equal to a width of the conformal via when viewed in the thickness direction.

4. The printed wiring board according to any one of claims 1 to 3,
wherein the multilayer substrate includes a through hole that penetrates through the multilayer substrate in the thickness direction and a through-hole conductor is provided on an inner wall of the through hole,
the build-up layer includes a surface layer conductor constituting part of the first surface,
the surface layer conductor is electrically connected to the through-hole conductor, and
when a thickness of the through-hole conductor is t1 and a thickness of the surface layer conductor is t2, t1/t2 is greater than or equal to 0.7 and less than or equal to 1.0.

5. The printed wiring board according to claim 4,
wherein the surface layer conductor is electrically connected to the via conductor.

6. The printed wiring board according to any one of claims 1 to 5,
wherein the build-up layer has a higher volume percentage of conductor than the core layer.

7. The printed wiring board according to any one of claims 1 to 6,
wherein the filled via includes a conductor that fills a via hole provided in part of an insulator of the multilayer substrate and the filled via is oriented with a part along a bottom of the via hole positioned towards the conformal via, and
the conformal via includes a conductor located along a side and a bottom of a via hole provided in another part of the insulator, and the conformal via is oriented with a part along the bottom positioned towards the filled via.

8. A printed wiring board manufacturing method comprising:
forming a via-hole-formed element by forming a first via hole from one surface of a core layer element and forming a second via hole from another surface of the core layer element, the core layer element to become a core layer;
forming a plated-via-formed element by performing a plating process on the via-hole-formed element and forming a first filled via in the first via hole and forming a conformal via in the second via hole, the conformal via being electrically connected to the first filled via;
forming a multilayer substrate element by stacking a build-up sheet on at least the one surface of the plated-via-formed element, the build-up sheet to become a build-up layer;
forming a via-hole-formed multilayer substrate element by forming a third via hole at a position overlapping at least part of the conformal via when viewed in a thickness direction, the third via hole being formed from a surface of the multilayer substrate element on a side where the one surface is located, and
forming a second filled via in the third via hole by performing a plating process on the via-hole-formed multilayer substrate element, the second filled via being electrically connected to the first filled via.

9. The printed wiring board manufacturing method according to claim 8,
wherein in forming the multilayer substrate element, a build-up sheet is additionally stacked on the other surface of the plated-via-formed element and an insulator contained in the build-up sheet fills a recess of the conformal via.

10. The printed wiring board manufacturing method according to claim 8 or 9,
further comprising: forming a through hole that penetrates through the via-hole-formed multilayer substrate element in a thickness direction before performing a plating process on the via-hole-formed multilayer substrate element,
wherein in the plating process performed on the via-hole-formed multilayer substrate element, the second filled via is formed in the third via hole and a through hole conductor is formed on an inner wall of the through hole by the plating process.
